# EUROPEAN PATENT APPLICATION

(11) **EP 3 273 590 A1**
(43) Date of publication of application: **24.01.2018**
(21) Application number: 17181495.7
(22) Date of filing: 14.07.2017
(51) Int. Cl.: H02M 7/487, H02M 7/219, H02M 1/00, H02M 1/34

(54) **SOFT SWITCHING AUXILIARY CIRCUIT, THREE-LEVEL THREE-PHASE ZERO-VOLTAGE CONVERSION CIRCUIT**

(30) Priority: 18.07.2016 CN 201610570714
(71) Applicant: Vertiv Tech Co., Ltd., Guangdong 518055 (CN)
(72) Inventor: XU, Fubin, Shenzhen, Guangdong 518057 (CN); HUANG, Hai, Shenzhen, Guangdong 518057 (CN); BING, Yang, Shenzhen, Guangdong 518057 (CN)
(74) Representative: Harden, Henry Simon

(57) **Abstract**

The present invention discloses a soft switching auxiliary circuit, comprising: an auxiliary coupling inductor configured to receive currents from a respective branch of a main circuit connected to the soft switching auxiliary circuit and perform a current sharing outputting; a clamping diode configured to receive an inductive voltage from the auxiliary coupling inductor and feed the inductive voltage back to a main switch transistor of the main circuit; an auxiliary switch transistor configured to receive a current from the main switch transistor of the main circuit and output the current to the clamping diode. The present invention further discloses a three-level three-phase zero-voltage conversion circuit. By means of the present invention, it is possible to reduce hard switching loss, to improve system switching frequency, to improve efficiency and to reduce electromagnetic interference.

## Description

### TECHNICAL FIELD

The present invention pertains to the filed of power electronic technology, and particularly to a soft switching auxiliary circuit and a three-level three-phase zero-voltage conversion circuit.

### BACKGROUND ART

The development of power electronic devices is orientated at miniaturization, lightweight, high efficiency, and low cost. In the past, this goal was generally achieved by adopting a method of improving a switching frequency, but this will cause problems such as extra switching loss, electromagnetic interference noise, ringing and the like. Multi-level conversion technique enables the volume and weight of an output filter to be reduced more effectively under the same switching frequency condition, while reducing harmonics content in output waveforms effectively, so as to reduce a switching stress, making it possible to improve efficiency within a predetermined range. Three-level circuits have been widely applied in power electronic power sources such as communication power sources, uninterrupted power sources UPSs, photovoltaic power sources and the like.

With the continuously-increasing requirements for high efficiency, high power density and low cost, use of a high performance device to improve the switching frequency and the multi-level technique still cannot satisfy the requirements in market competitions. By increasing the switching frequency, application of the high performance device can reduce the inductance of a passive device and the volume of a transformer and a capacitor, but at the same time will result in an increase in switching loss, such that it is difficult to ensure the efficiency to be improved, thus failing to simultaneously satisfy the requirements of high power density and high efficiency. The operating frequency of the existing common devices is limited, and even if the operating frequency can be increased to 100 kHz or even MHz along with the development of high performance devices SiC, GaN, the application of the high performance devices makes more strict requirements for techniques such as PCB layout, driving, active clamping and the like. In terms of the existing power electronic technique, there is still a long way to go for the application and promotion of the high performance devices, and the stability and cost of the application of the devices are constraint keys. The proposal of topologies such as multi-level technique, interleaving, polymorphy and the like will improve the efficiency to some extent, but it still fails to satisfy market requirements. To realize high efficiency, high power density and low cost, the problems of the switching devices in regard to large switching loss, large cooling fin, low system operating frequency and large size of magnetic core element must be solved starting from the actual root. Common power devices MOSFETs or IGBTs are developing rapidly, and also their performances are gradually improved and their loss are gradually lowered; however, hard switching is still a bottleneck for system high power density, high efficiency and low cost. Therefore, the study and application of soft switching will develop a newer field for power electronic products.

### SUMMARY OF THE INVENTION

In view of this, a main object of the present invention is to provide a soft switching auxiliary circuit and a three-level three-phase zero-voltage conversion circuit.

To achieve the above object, the technical solution of the present invention is carried out as follows:
An embodiment of the present invention provides a soft switching auxiliary circuit, comprising:
   an auxiliary coupling inductor configured to receive currents from a respective branch of a main circuit connected to the soft switching auxiliary circuit and perform a current sharing outputting;
   a clamping diode configured to receive an inductive voltage from the auxiliary coupling inductor and feed the inductive voltage back to a main switch transistor of the main circuit;
   an auxiliary switch transistor configured to receive a current from the main switch transistor of the main circuit and output the current to the clamping diode.

In the above solution, the soft switching auxiliary circuit further comprises:
a freewheeling diode configured to receive the inductive voltage from the auxiliary coupling inductor and output the inductive voltage to the main switch transistor of the main circuit.

An embodiment of the present invention further provides a soft switching auxiliary circuit, wherein the soft switching auxiliary circuit is connected in parallel with a main switch transistor of a main circuit, and the soft switching auxiliary circuit comprises an auxiliary coupling inductor, a clamping diode and an auxiliary switch transistor, wherein the auxiliary coupling inductor has an input connected with a respective branch of the main circuit and an output connected with the clamping diode, the clamping diode is connected with one terminal of the main switch transistor, another terminal of the main switch transistor is connected with the auxiliary switch transistor, and the auxiliary switch transistor is connected with the clamping diode.

In the above solution, the auxiliary coupling inductor has another output connected with the freewheeling diode, the freewheeling diode is connected with one terminal of the main switch transistor.

An embodiment of the present invention further provides a three-level three-phase zero-voltage conversion circuit, comprising: a three-level three-phase main circuit and two auxiliary circuits, wherein upper arms of three branches of the three-level three-phase main circuit are respectively connected with one auxiliary circuit to constitute an upper soft switching circuit, and lower arms of the three branches of the three-level three-phase main circuit are respectively connected with the other auxiliary circuit to constitute a lower soft switching circuit, the two auxiliary circuits being connected with each other, wherein each of the two auxiliary circuits comprises an auxiliary coupling inductor, a clamping diode and an auxiliary switch transistor, wherein the auxiliary coupling inductor has an input connected with a respective branch of the main circuit and an output connected with the clamping diode, one terminal of the main switch transistor is connected with the auxiliary switch transistor, and the auxiliary switch transistor is connected with the clamping diode, and wherein the clamping diodes of the two auxiliary circuits are connected with each other.

In the above solution, unidirectional conductive diodes are connected between the auxiliary circuit and the upper and lower arms of the three branches of the three-level three-phase main circuit respectively.

In the above solution, the auxiliary coupling inductor of each of the two auxiliary circuits has another output connected with a freewheeling diode, and the clamping diodes and the freewheeling diodes of the two auxiliary circuits are connected with each other to be combined into one circuit.

An embodiment of the present invention further provides a three-level three-phase zero-voltage conversion circuit, comprising: a three-level three-phase main circuit and two auxiliary circuits, wherein upper arms of three branches of the three-level three-phase main circuit are respectively connected with one auxiliary circuit to constitute an upper soft switching circuit, and lower arms of the three branches of the three-level three-phase main circuit are respectively connected with the other auxiliary circuit to constitute a lower soft switching circuit, the two auxiliary circuits being connected with each other, wherein each of the two auxiliary circuits comprises an auxiliary coupling inductor, a clamping diode and an auxiliary switch transistor, wherein the auxiliary coupling inductor has an input connected with a respective branch of the main circuit and an output connected with the clamping diode, the clamping diode is connected with one terminal of the main switch transistor, another terminal of the main switch transistor is connected with the auxiliary switch transistor, and the auxiliary switch transistor is connected with the clamping diode, and wherein the clamping diodes of the two auxiliary circuits are connected with each other.

In the above solution, unidirectional conductive diodes are connected between the auxiliary circuit and the upper and lower arms of the three branches of the three-level three-phase main circuit respectively.

In the above solution, the auxiliary coupling inductor of each of the two auxiliary circuits has another output connected with a freewheeling diode, the two freewheeling diodes are connected with the main switch transistor.

As compared with the prior art, the present invention produces the following advantageous effects:
The soft switching auxiliary circuit according to the present invention can reduce hard switching loss, improve system switching frequency, improve efficiency and reduce electromagnetic interference. By specific carriers, it can effectively reduce the number of times of auxiliary switch conversion, and can offset harmonics of specific order number, improve input harmonics characteristics, and reduce input current THDi; by the auxiliary coupling inductor in the soft switching circuit, it can mitigate the problem in regard to a too large auxiliary transistor stress resulting from sawtooth wave modulation, and automatically current-share the currents of the auxiliary branches, and optimize diode reverse recovery characteristic and current change waveforms; by an auxiliary active switching operation, it can force a coupling inductive voltage to be changed and converted to a current, and by using auxiliary inductor and capacitor resonance, it can cause energy feedback of the current through an auxiliary diode, and mitigate the problem of reverse recovery of the diode and the problem of hard switching of the main switch transistor.

There is no need for the zero-voltage conversion circuit according to the present invention to select one auxiliary circuit for each phase to solve the problem of hard switching of a main switch transistor. With the aid of diode single-phase conduction characteristic, by means of logic line AND, with use of one coupling inductor and one auxiliary switch transistor, one freewheeling diode and a plurality of anti-irrigation diodes, it solves the problem of hard switching of a main transistor in a circuit system, and reduces the cost of three-phase soft switching; meanwhile, by adopting specific sawtooth wave modulation, it simplifies PWM control such that the control characteristic of the system is more optimized and better.

### BRIEFT DESCRIPTION OF THE DRAWINGS

FIG. 1 is a circuit diagram of a soft switching auxiliary circuit provided by Embodiment 1 of the present invention;
FIG. 2 is a circuit diagram of a soft switching auxiliary circuit provided by Embodiment 2 of the present invention;
FIG. 3 is a circuit diagram of a three-level three-phase zero-voltage conversion circuit provided by Embodiment 3 of the present invention;
FIG. 4 is a turn-on and turn-off waveform diagram of an auxiliary switch transistor and a diode of the three-level three-phase zero-voltage conversion circuit provided by Embodiment 3 of the present invention;
FIG. 5 is a waveform diagram of the auxiliary switch transistor of the three-level three-phase zero-voltage conversion circuit provided by Embodiment 3 of the present invention;
FIG. 6 is a circuit diagram of a three-level three-phase zero-voltage conversion circuit provided by Embodiment 4 of the present invention;

### DETAILED DESCRIPTION OF THE EMBODIMENTS

Hereinafter, the present invention will be described in detail combined with the appended drawings and specific embodiments.

An embodiment of the present invention provides a soft switching auxiliary circuit, comprising:
an auxiliary coupling inductor configured to receive currents from a respective branch of a main circuit connected to the soft switching auxiliary circuit and perform a current sharing outputting;
a clamping diode configured to receive an inductive voltage from the auxiliary coupling inductor and feed the inductive voltage back to a main switch transistor of the main circuit;
an auxiliary switch transistor configured to receive a current from the main switch transistor of the main circuit and output the current to the clamping diode.

The soft switching auxiliary circuit further comprises:
a freewheeling diode configured to receive the inductive voltage from the auxiliary coupling inductor and output the inductive voltage to the main switch transistor of the main circuit.

The soft switching auxiliary circuit can be used for various DC/DC, interleaved, polymorphic, two-level or multi-level inversion or rectification topological structures.

An embodiment of the present invention further provides a soft switching auxiliary circuit, wherein the soft switching auxiliary circuit is connected in parallel with a main switch transistor of a main circuit, and comprises an auxiliary coupling inductor, a clamping diode and an auxiliary switch transistor, wherein the auxiliary coupling inductor has an input connected with a respective branch of the main circuit and an output connected with the clamping diode, the clamping diode is connected with one terminal of the main switch transistor, another terminal of the main switch transistor is connected with the auxiliary switch transistor, and the auxiliary switch transistor is connected with the clamping diode.

The auxiliary coupling inductor has another output connected with the freewheeling diode, the freewheeling diode is connected with one terminal of the main switch transistor.

An embodiment of the present invention further provides a three-level three-phase zero-voltage conversion circuit, comprising: a three-level three-phase main circuit and two auxiliary circuits, wherein upper arms of three branches of the three-level three-phase main circuit are respectively connected with one auxiliary circuit to constitute an upper soft switching circuit, and lower arms of the three branches of the three-level three-phase main circuit are respectively connected with the other auxiliary circuit to constitute a lower soft switching circuit, the two auxiliary circuits being connected with each other, wherein each of the two auxiliary circuits comprises an auxiliary coupling inductor, a clamping diode and an auxiliary switch transistor, wherein the auxiliary coupling inductor has an input connected with a respective branch of the main circuit and an output connected with the clamping diode, one terminal of the main switch transistor is connected with the auxiliary switch transistor, and the auxiliary switch transistor is connected with the clamping diode, and wherein the clamping diodes of the two auxiliary circuits are connected with each other.

Unidirectional conductive diodes are connected between the auxiliary circuit and the upper and lower arms of the three branches of the three-level three-phase main circuit respectively.

The auxiliary coupling inductor of each of the two auxiliary circuits has another output connected with a freewheeling diode, and the clamping diodes and the freewheeling diodes of the two auxiliary circuits are connected with each other to be combined into one circuit.

An embodiment of the present invention further provides a three-level three-phase zero-voltage conversion circuit, comprising: a three-level three-phase main circuit and two auxiliary circuits, wherein upper arms of three branches of the three-level three-phase main circuit are respectively connected with one auxiliary circuit to constitute an upper soft switching circuit, and lower arms of the three branches of the three-level three-phase main circuit are respectively connected with the other auxiliary circuit to constitute a lower soft switching circuit, the two auxiliary circuits being connected with each other, wherein each of the two auxiliary circuits comprises an auxiliary coupling inductor, a clamping diode and an auxiliary switch transistor, wherein the auxiliary coupling inductor has an input connected with a respective branch of the main circuit and an output connected with the clamping diode, the clamping diode is connected with one terminal of the main switch transistor, another terminal of the main switch transistor is connected with the auxiliary switch transistor, and the auxiliary switch transistor is connected with the clamping diode, and wherein the clamping diodes of the two auxiliary circuits are connected with each other.

Unidirectional conductive diodes are connected between the auxiliary circuit and the upper and lower arms of the three branches of the three-level three-phase main circuit respectively.

The auxiliary coupling inductor of each of the two auxiliary circuits has another output connected with a freewheeling diode, the two freewheeling diodes are connected with the main switch transistor.

### Embodiment 1:

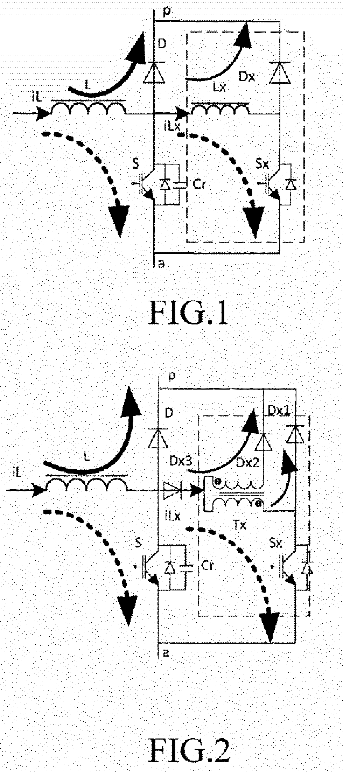

As shown in FIG. 1, Embodiment 1 of the present invention provides a soft switching auxiliary circuit, wherein the soft switching auxiliary circuit is connected in parallel with a main switch transistor of a main circuit, and comprises an auxiliary coupling inductor Lx, a clamping diode Dx and an auxiliary switch transistor Sx, wherein the auxiliary coupling inductor Lx has an input connected with a respective branch of the main circuit and an output connected with the clamping diode Dx, the clamping diode Dx is connected with one terminal of the main switch transistor S, another terminal of the the main switch transistor S is connected with the auxiliary switch transistor Sx, and the auxiliary switch transistor Sx is connected with the clamping diode Dx.

The soft switching auxiliary circuit (in the dashed frame) is directly connected in parallel with the main switch transistor S, which may achieve a soft switch-on effect of the auxiliary switch transistor Sx and the main switch transistor S and a soft recovery of the main transistor diode D, so as to produce an softening effect of a dashed-line current when being converted to a real-line current; wherein the clamping diode Dx can perform the functions of clamping and energy feedback with respect to the auxiliary switch transistor Sx and changes in the auxiliary inductive voltage, for absorbing a peak of a voltage stress of the auxiliary switch transistor Sx, and is more suitable for DC/DC topology and small-power situations.

### Embodiment 2:

As shown in FIG. 2, Embodiment 2 of the present invention provides a soft switching auxiliary circuit, wherein the soft switching auxiliary circuit is connected in parallel with a main switch transistor of a main circuit, and comprises an auxiliary coupling inductor Tx, a clamping diode Dx1, an auxiliary switch transistor Sx, and a freewheeling diode Dx2, wherein the auxiliary coupling inductor Tx has an input connected with a respective branch of the main circuit and an output connected with the clamping diode Dx1, the clamping diode Dx1 is connected with one terminal of the main switch transistor S, another terminal of the main switch transistor S is connected with the auxiliary switch transistor Sx, the auxiliary switch transistor Sx is connected with the clamping diode Dx1, the auxiliary coupling inductor Tx has another output connected with the freewheeling diode Dx2, and the freewheeling diode is connected with one terminal of the main switch transistor S.

A unidirectional conductive diode Dx3 is connected between the input of the auxiliary coupling inducer Tx and the respective branch of the main circuit.

The soft switching auxiliary circuit (in the dashed frame) is directly connected in parallel with the main switch transistor S, which may also achieve a soft switch-on effect of the auxiliary switch transistor Sx and the main switch transistor S and a soft recovery of the main transistor diode D, so as to further soften a dashed-line current when being converted to a real-line current; wherein Dx1 can perform the functions of clamping and energy feedback with respect to the auxiliary switch transistor Sx and changes of the auxiliary inductive voltage, and Dx2 mainly performs the functions of clamping and energy feedback. The soft switching auxiliary circuit has the following main advantages: by the coupling inductor, it can equally divide a resonance current at the time of conversion, and reduce current stresses of the auxiliary switch transistor, the diode and the inductor ; in addition, due to the unidirectional conduction characteristic of Dx3, passive resonance can only be unidirectional, thus reducing passive resonance loss, and feeding energy to a bus voltage to the largest extent; by utilizing the characteristic of the diode being conductive unidirectionally and being cut-off reversely (equivalent to infinite resistance), a logic line AND combination can be used in a three-phase system, thus being more suitable to AC, interleaved and parallel-connected, polymorphic and multi-level topologies, and exhibiting a more apparent advantage of large power.

### Embodiment 3:

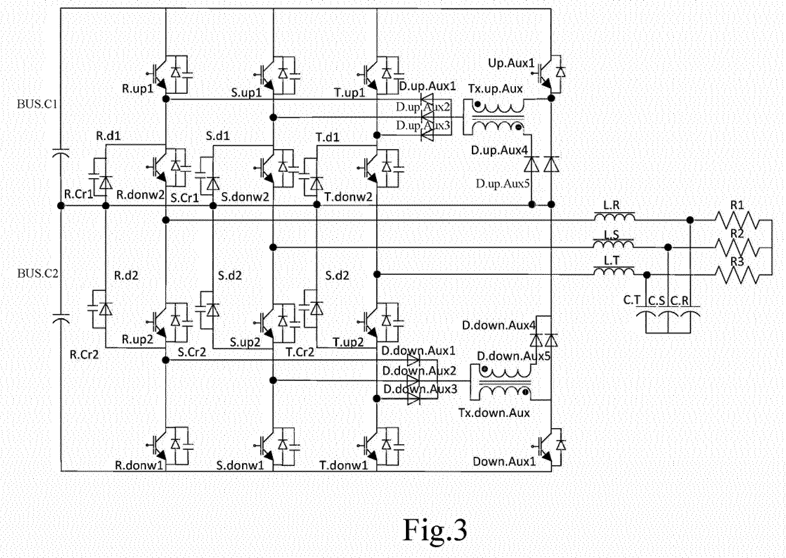

As shown in FIG. 3, Embodiment 3 of the present invention provides a three-level three-phase zero-voltage conversion circuit, comprising: a three-level three-phase main circuit and two auxiliary circuits, wherein upper arms of three branches of the three-level three-phase main circuit are respectively connected with one auxiliary circuit to constitute an upper soft switching circuit, and lower arms of the three branches of the three-level three-phase main circuit are respectively connected with the other auxiliary circuit to constitute a lower soft switching circuit, the two auxiliary circuits being connected with each other, wherein each of the two auxiliary circuits comprises an auxiliary coupling inductor, a clamping diode and an auxiliary switch transistor, wherein the auxiliary coupling inductor has an input connected with a respective branch of the main circuit and an output connected with the clamping diode, one terminal of the main switch transistor is connected with the auxiliary switch transistor, and the auxiliary switch transistor is connected with the clamping diode, and wherein the clamping diodes of the two auxiliary circuits are connected with each other.

Unidirectional conductive diodes are connected between the auxiliary circuit and the upper and lower arms of the three branches of the three-level three-phase main circuit respectively.

The auxiliary coupling inductor of each of the two auxiliary circuits has another terminal connected with a freewheeling diode, and the clamping diodes and the freewheeling diodes of the two auxiliary circuits are connected with each other to be combined into one circuit.

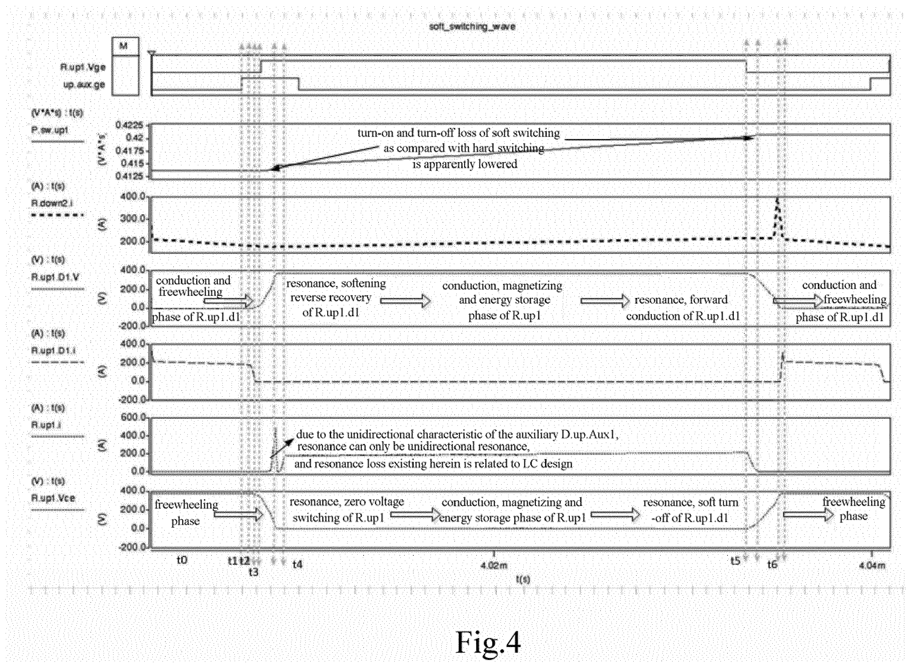

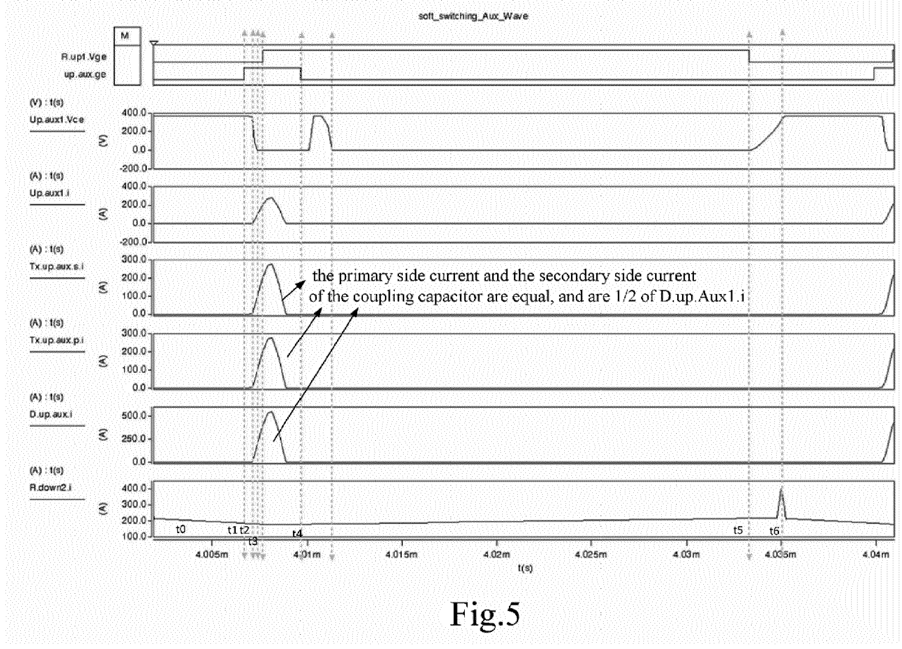

Specifically, referring to FIGS. 4 and 5, an R-phase output voltage is assumed to be in a positive half cycle and PF=1, at this time a positive arm operates in a Buck operation mode, R.up1 is a high-frequency transistor, and R.down2 is a low-frequency transistor and is conductive all the time. A freewheeling diode R.d1 is assumed to be conductive to release magnetism in an initial state, at this time an auxiliary switch transistor Up.Aux1 and a main switch transistor R.up1 are cut-off, and current flows out of the freewheeling diode R.d1, R.down2, and L.R.

Model11(t1∼t2): Up.Aux1 is turned on; since the auxiliary coupling inductor Tx.up.Aux limits a rising rate di/dt of current in the auxiliary circuit, the turn-on process of the auxiliary switch transistor Up.Aux1 can be softened, and meanwhile the auxiliary coupling inductor Tx.up.Aux also reduces a declining rate di/dt of current of R.d1, suppressing a reverse recovery current of R.d1 effectively, thus realizing soft recovery of R.d1. Due to the current sharing function of the auxiliary coupling inductor, a current stress of the auxiliary transistor will be assigned to each auxiliary switch transistor equally, so as to reduce an auxiliary current stress.

Model2(t2∼t3): after Up.Aux1 is turned on for a period of time, current is completely transferred to the auxiliary switch transistor, accompanied by LC resonance, so as to realize charging of R.up1 in a direction where the capacitor is connected in parallel, with the upper portion being positive and the lower portion being negative, wherein when capacitor voltage is greater than a conductive voltage of the body diode of R.up1, forward conduction of the body diode of R.up1 is realized, such that the LC resonance terminates, and R.up1 is turned on, and meanwhile zero voltage switching of R.up1 can be realized, thereby starting a Buck magnetizing mode of the main transistor.

Model3(t3∼t4): after the zero voltage switching of R.up1, current is transferred from the auxiliary transistor circuit to the main switch transistor circuit; upon complete transfer of the current, Up.Aux1 is turned off; since R.up1 performs a clamping conductive function, approximate zero-voltage zero-current turn-off of the auxiliary transistor can be realized, and plus the unidirectional current flow characteristic of D.up.Aux1, natural inversion of the auxiliary diode can be realized after the LC resonance reaches zero.

Model4(t4∼t5): when it is required to turn off R.up1, due to the characteristic that capacitor voltage cannot change abruptly and the characteristic that the LC resonance has small damping, LC resonates with high frequencies, also realizing reverse charging of the junction capacitance of R.up1, thus making it possible to soften the turn-off process of R.up1. At this time, the auxiliary circuit and the main freewheeling diode simultaneously undertake the functions of freewheeling and magnetism releasing.

Model5(t5∼t6): after R.up1 is turned off, also due to the unidirectional current flow characteristic of D.up.Aux1, the LC resonance terminals, and the main freewheeling diode undertakes all the freewheeling and magnetizing processes.

Model6(t0∼t6): one switching cycle terminals, and a next switching cycle starts. The process is as described above.

The operating principle of the respective devices in a negative half cycle of the output voltage is the same as the operating principle of the respective devices in the positive half cycle thereof. The operating principles of the remaining two phases are the same as the operating principle of the R-phase, and will not be described repeatedly.

As can be seen from FIG. 4 and FIG. 5, the auxiliary circuit according to the present invention can reduce hard switching loss. By the auxiliary coupling inductor in the soft switching circuit, it can mitigate the problem in regard to a too large auxiliary transistor stress resulting from sawtooth wave modulation, and automatically current-share the currents of the auxiliary branches, and optimize diode reverse recovery characteristic and current change waveforms; by an auxiliary active switching operation, it can force a coupling inductive voltage to be changed and converted to a current, and by using auxiliary inductor and capacitor resonance, it can cause energy feedback of the current through an auxiliary diode, and improve the problem of reverse recovery of the diode and the problem of hard switching of the main switch transistor; it can cause ZVT to be turned on and soft-turned off, such that the reverse recovery of the diode is weakened; by the realization of the soft switching, in actual cases it can improve system switching frequency, improve efficiency and reduce electromagnetic interference; and by specific carriers, it can effectively reduce the number of times of auxiliary switch conversion, and can offset harmonics of specific order number, improve input harmonics characteristics, and reduce input current THDi.

The zero-voltage conversion circuit according to the present invention is not required that each phase selects to use one auxiliary circuit to solve the problem of hard switching of a main switch transistor. With the aid of diode single-phase conduction characteristic, by means of logic line AND, with use of one coupling inductor and one auxiliary switch transistor, one freewheeling diode and a plurality of anti-irrigation diodes, it solves the problem of hard switching of a main transistor in a circuit system, and reduces the cost of three-phase soft switching; meanwhile, by adopting specific sawtooth wave modulation, it simplifies PWM control such that the control characteristic of the system is more optimized and better.

### Embodiment 4:

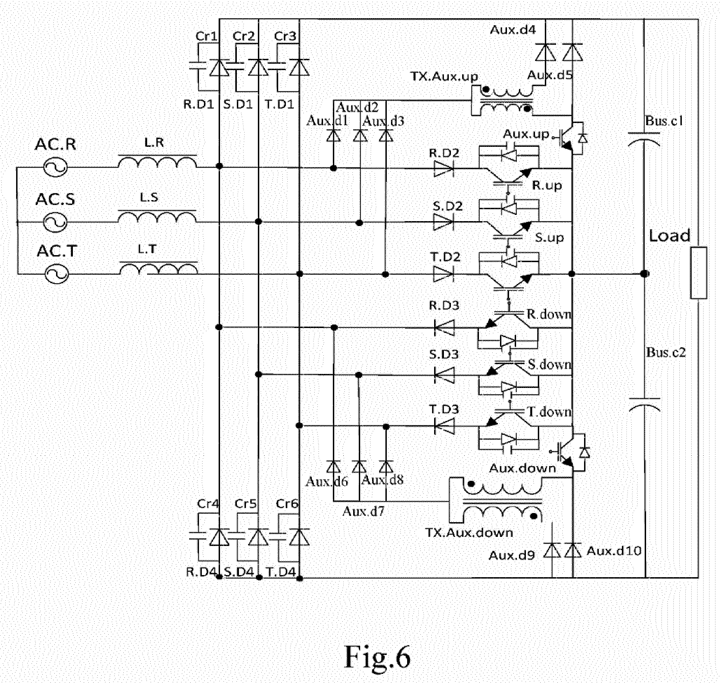

As shown in FIG. 6, Embodiment 4 of the present invention provides a three-level three-phase zero-voltage conversion circuit, comprising: a three-level three-phase main circuit and two auxiliary circuits, wherein upper arms of three branches of the three-level three-phase main circuit are respectively connected with one auxiliary circuit to constitute an upper soft switching circuit, and lower arms of the three branches of the three-level three-phase main circuit are respectively connected with the other auxiliary circuit to constitute a lower soft switching circuit, the two auxiliary circuits being connected with each other, wherein each of the two auxiliary circuits comprises an auxiliary coupling inductor, a clamping diode and an auxiliary switch transistor, wherein the auxiliary coupling inductor has an input connected with a respective branch of the main circuit and an output connected with the clamping diode, the clamping diode is connected with one terminal of the main switch transistor, another terminal of the main switch transistor is connected with the auxiliary switch transistor, and the auxiliary switch transistor is connected with the clamping diode, and wherein the clamping diodes of the two auxiliary circuits being connected with each other.

Unidirectional conductive diodes are connected between the auxiliary circuit and the upper and lower arms of the three branches of the three-level three-phase main circuit respectively.

The auxiliary coupling inductor of each of the two auxiliary circuits has another output connected with a freewheeling diode, and the two freewheeling diodes are connected with the main switch transistor.

Those described above are only preferred embodiments of the present invention, but are not used for limiting the scope of protection of the present invention.

## Claims

1. A soft switching auxiliary circuit, **characterized by** comprising:
an auxiliary coupling inductor configured to receive currents from a respective branch of a main circuit connected to the soft switching auxiliary circuit and perform a current sharing outputting;
a clamping diode configured to receive an inductive voltage from the auxiliary coupling inductor and feed the inductive voltage back to a main switch transistor of the main circuit;
an auxiliary switch transistor configured to receive a current from the main switch transistor of the main circuit and output the current to the clamping diode.

2. The soft switching auxiliary circuit according to claim 1, **characterized by** further comprising:
a freewheeling diode configured to receive the inductive voltage from the auxiliary coupling inductor and output the inductive voltage to the main switch transistor of the main circuit.

3. A soft switching auxiliary circuit, **characterized in that**: the soft switching auxiliary circuit is connected in parallel with a main switch transistor of a main circuit, and the soft switching auxiliary circuit comprises an auxiliary coupling inductor, a clamping diode and an auxiliary switch transistor, wherein the auxiliary coupling inductor has an input connected with a respective branch of the main circuit and an output connected with the clamping diode, the clamping diode is connected with one terminal of the main switch transistor, another terminal of the main switch transistor is connected with the auxiliary switch transistor, and the auxiliary switch transistor is connected with the clamping diode.

4. The soft switching auxiliary circuit according to claim 3, **characterized in that**: the auxiliary coupling inductor has another output connected with the freewheeling diode, the freewheeling diode is connected with one terminal of the main switch transistor.

5. A three-level three-phase zero-voltage conversion circuit, **characterized by** comprising: a three-level three-phase main circuit and two auxiliary circuits, wherein upper arms of three branches of the three-level three-phase main circuit are respectively connected with one auxiliary circuit to constitute an upper soft switching circuit, and lower arms of the three branches of the three-level three-phase main circuit are respectively connected with the other auxiliary circuit to constitute a lower soft switching circuit, the two auxiliary circuits being connected with each other, wherein each of the two auxiliary circuits comprises an auxiliary coupling inductor, a clamping diode and an auxiliary switch transistor, wherein the auxiliary coupling inductor has an input connected with a respective branch of the main circuit and an output connected with the clamping diode, one terminal of the main switch transistor is connected with the auxiliary switch transistor, and the auxiliary switch transistor is connected with the clamping diode, and wherein the clamping diodes of the two auxiliary circuits are connected with each other.

6. The three-level three-phase zero-voltage conversion circuit according to claim 5, **characterized in that**: unidirectional conductive diodes are connected between the auxiliary circuit and the upper and lower arms of the three branches of the three-level three-phase main circuit respectively.

7. The three-level three-phase zero-voltage conversion circuit according to claim 5, **characterized in that**: the auxiliary coupling inductor of each of the two auxiliary circuits has another output connected with a freewheeling diode, and the clamping diodes and the freewheeling diodes of the two auxiliary circuits are connected with each other to be combined into one circuit.

8. A three-level three-phase zero-voltage conversion circuit, **characterized by** comprising: a three-level three-phase main circuit and two auxiliary circuits, wherein upper arms of three branches of the three-level three-phase main circuit are respectively connected with one auxiliary circuit to constitute an upper soft switching circuit, and lower arms of the three branches of the three-level three-phase main circuit are respectively connected with the other auxiliary circuit to constitute a lower soft switching circuit, the two auxiliary circuits being connected with each other, wherein each of the two auxiliary circuits comprises an auxiliary coupling inductor, a clamping diode and an auxiliary switch transistor, wherein the auxiliary coupling inductor has an input connected with a respective branch of the main circuit and an output connected with the clamping diode, the clamping diode is connected with one terminal of the main switch transistor, another terminal of the main switch transistor is connected with the auxiliary switch transistor, and the auxiliary switch transistor is connected with the clamping diode, and wherein the clamping diodes of the two auxiliary circuits are connected with each other.

9. The three-level three-phase zero-voltage conversion circuit according to claim 8, **characterized in that**: unidirectional conductive diodes are connected between the auxiliary circuit and the upper and lower arms of the three branches of the three-level three-phase main circuit respectively.

10. The three-level three-phase zero-voltage conversion circuit according to claim 8, **characterized in that**: the auxiliary coupling inductor of each of the two auxiliary circuits has another output connected with a freewheeling diode, the two freewheeling diodes are connected with the main switch transistor.
